# EUROPEAN PATENT APPLICATION

(11) **EP 0 897 257 A2**
(43) Date of publication of application: **17.02.1999**
(21) Application number: 98304712.7
(22) Date of filing: 15.06.1998
(51) Int. Cl.: H05K 9/00, B05D 7/24

(54) **Electromagnetic shielding**

(30) Priority: 20.06.1997 GB 9713108
(71) Applicant: Nova Tran Limited, Northampton, NN2 6EH (GB)
(72) Inventor: Noordegraaf, Jan, Dry Sandford, Abingdon, OX13 6JP (GB); Hull, Harry Edward, Wootton, Northampton NN4 6LF (GB); Davis, Paul, West Malling, Kent, ME19 4FJ (GB)
(74) Representative: Allard, Susan Joyce

(57) **Abstract**

A transparent electromagnetic shielding composite which comprises
(i) a transparent insulating layer from 0.1 to 75 micrometres in thickness of a polymeric p-xylylene comprising repeating units of the formula 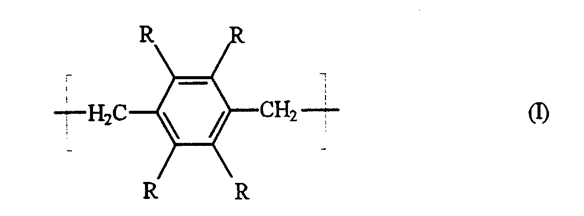 where each R is independently selected from the group consisting of a hydrogen atom, a chlorine atom, a fluorine atom, a carboxyl group and a lower C₁-C₆ alkyl group; and
(ii) a transparent coating on the polymeric p-xylylene layer of indium tin oxide from 10 Angstroms to 50 micrometres in thickness.

The shielding composites of the present invention have improved properties and can be used for the electromagnetic shielding of printed circuit boards.

## Description

The present invention relates to the electromagnetic shielding of substrate surfaces and, in particular, to the use of a particular conformal coating composition in electromagnetic shielding applications.

Electrical and electronic devices and systems are considered to be electronically compatible when they work as intended, both within themselves and in their electromagnetic environment. However, electromagnetic interference (EMI) occurs when unwanted voltages or currents are present which affect the performance of a device or system. Although designers do not intend that their devices should be sources of interference, a signal from one path may inadvertently couple into another path to form noise or interference. There are many sources of interference, for example, arc discharge, corona discharge from high power lines, signal leakage from cable television systems, fluorescent lamps, automotive systems and industrial, scientific and medical equipment.

It is possible to electrically shield devices and systems from electromagnetic interference by imposing a metal or composite barrier between the source or sources of electrical noise and the device or system. Examples of such barriers are the casing or housing of equipment, shields covering interconnecting cables between equipment, shielded rooms etc.

Not only is it necessary for the devices or systems to be shielded from electromagnetic radiation, but increasing demands are being made upon the companies to construct devices in which the different component parts of the device are shielded from one another. This is particularly important in respect of the shielding of components on printed circuit boards. A review of the requirements for the suppression of electromagnetic interference is given in Information Display, 1/97, "Designing for Electromagnetic Compatibility" by Barber, R., Gaynor, P., and Reinheimer, E.

Shielding over a wide range of frequencies of from 30 MH_{z} to 100 GH_{z} is required. Wide band gap semiconductor materials have been used as shielding materials to provide good chemical durability and excellent electrical and optical properties. For example, sputtered coatings of indium tin oxide may be used for this purpose. However, many substrates, such as printed circuit boards, cannot be simply coated with indium tin oxide as the coating would affect the functioning of the circuits.

Another problem with providing electromagnetic shielding to substrates such as printed circuit boards which have various electrical components attached thereto is that it is clearly advantageous if the identity of the particular components can be established after the shielding layer has been applied thereto. There is therefore a need for improved electromagnetic shielding materials for use in the shielding of printed circuit boards and the like.

We have now developed an extremely thin transparent coating with electromagnetic shielding properties which can be used to provide an insulating layer on a surface which provides electromagnetic shielding for frequencies of from 20 to 300 MHz, in particular frequencies of from 100 to 150 MHz.

Accordingly, the present invention provides a transparent electromagnetic shielding composite which comprises
(i) a transparent insulating layer from 0.1 to 75 micrometres in thickness of a polymeric p-xylylene comprising repeating units of the formula 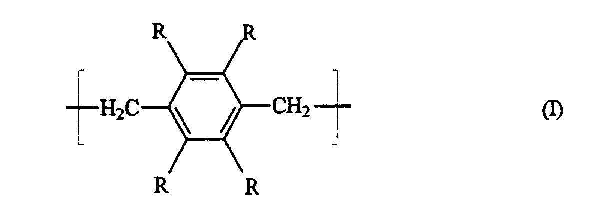 where each R is independently a hydrogen atom, a chlorine atom, a fluorine atom, a carboxyl group or a lower C₁-C₆ alkyl group; and
(ii) a transparent coating on the polymeric p-xylylene layer of indium tin oxide from 10 Angstroms to 50 micrometres in thickness.

Parylene is a generic term which is used to describe the poly-p-xylylenes of the general formula 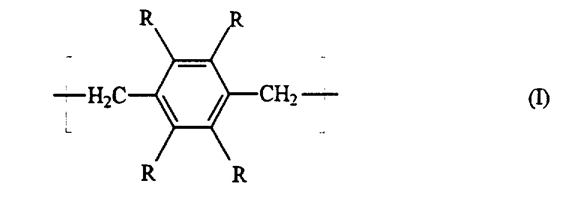 where R is a hydrogen atom, a chlorine atom or a fluorine atom. These polymers are prepared by the vapour deposition polymerization of a parylene dimer of the formula 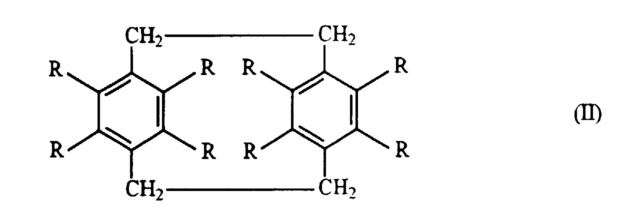 where R is as defined above. The preparation of parylene polymers is described, for example, in US Patents Nos. 2719131 and 3342754.

The four dimers of formula (II) which are preferred for use in the shielding composites of the present invention are:-

| | |
|---|---|
| Parylene N - | di-para-xylylene |
| Parylene C - | dichloro-di-para-xylylene |
| Parylene D - | tetrachloro-di-para-xylylene |
| Parylene AF4 - | tetrafluoro-di-para-xylylene |

Preferably the parylene layer which is used in the shielding composites of the present invention has a thickness in the range of from 10 to 20 micrometres, more preferably about 15 micrometres. The parylene layer provides electrical insulation of a substrate material to which it is applied.

Typically, the volume resistivity of the parylene coatings at 23°C and 50% relative humidity is as follows

| **Polymer** | **Volume Resistivity** Ω |
|---|---|
| Parylene N | 1.4 X 10¹⁷ |
| Parylene C | 8.8 X 10¹⁶ |
| Parylene D | 2 X 10¹⁶ |
| Parylene AF4 | 5.3 X 10¹⁶ |

The indium tin oxide layer which is applied to the parylene layer provides the electrical shielding by being connected to earth. The indium tin oxide layer preferably has a thickness of from 100 to 10,000 Angstroms, more preferably about 150 Angstroms.

Both the parylene layer and the indium tin oxide layer of the composite are transparent and this allows the identity of all components which are coated by the composite to be established.

A further advantage of the use of indium tin oxide in the electromagnetic shielding composites of the present invention is that the conductivity of the indium tin oxide layer can be controlled as a function of the thickness of the layer and the particular sputtering conditions used in applying the layer to the parylene coating. The manner in which indium tin oxide is sputtered from a target onto a surface to be coated is well known to those skilled in the art. Highly conductive indium tin oxide is reflective, whereas lower-conductivity has an effect on transmission and absorption. It has been demonstrated (Thin Film Solids, Vol 226, No. 1,15 April, 1993, Suzuki K. et al) that a thin layer of indium tin oxide deposited at a high speed of 12500 Angstrom/min showed an electromagnetic shielding performance of minus 30dB at 1 GHz.

Accordingly, it is possible by adjusting the conditions under which the indium tin oxide layer is applied to the parylene coating to obtain electromagnetic shielding composites which are effective over the range of from 50 to 300MHz.

The shielding composite of the present invention may additionally comprise a transparent coating on the conductive layer (ii), on the surface opposite the surface adjacent to the polymeric para-xylylene layer, of an insulating polymer. The insulating polymer is preferably a para-xylylene polymer as described above with a thickness in the range of from 0.1 to 75 micrometres, preferably from 10 to 20 micrometres.

The shielding composites of the present invention are generally applied to a substrate surface by the following process steps.

First, a transparent layer of polymeric para-xylylene is deposited on the substrate surface by the vapour deposition of a parylene dimer of Formula (II) detailed above. Because the polymerisation process is a vapour deposition process, the polymeric para-xylylene coating is formed on the substrate surface as a thin uniform film.

The indium tin oxide layer which is applied to the parylene layer is generally sputtered onto the surface of the parylene layer by means of a vacuum deposition process or by a plasma deposition process. Alternatively, a layer can be deposited using a spray deposition process; or a dip coating process.

When a third layer is used to provide a sandwich-type structure, the transparent insulating polymeric layer may be applied to the exposed surface of the indium tin oxide layer by any suitable technique. For example, when the insulating layer is a parylene layer then the same coating conditions as used for the deposition of the parylene layer on the substrate surface may also be used.

The present invention thus includes within its scope a process for the preparation of an electromagnetic shielding composite, which process comprises the steps of
a) applying to a substrate surface a transparent coating of 0.1 to 75 micrometres in thickness of a polymeric p-xylylene comprising repeating units of the formula 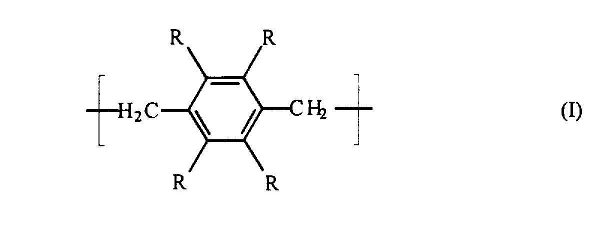 where R is as defined above by a polymeric vapour deposition process;
b) applying to the polymeric p-xylylene coating a transparent layer of indium tin oxide from 10 Angstroms to 200 micrometres in thickness, and
c) optionally applying to the layer of indium tin oxide a coating of a transparent insulating polymeric material.

In step (b) of the process, a coating up to 100 micrometres in thickness is obtained by sputtering, whilst a coating up to 200 micrometres may be obtained by dip coating.

The electromagnetic shielding composite of the present invention is of particular use in providing appropriate shielding for frequencies in the range of from 20 to 300 MHz, more specifically for frequencies in the range of from 100 to 150 MHz.

The present invention will be further described with reference to the following Example.

### EXAMPLE

A printed circuit board with ASIC's, IC's working at a frequency of 125 MHZ was selected for coating. A transparent parylene-C coating of 12 micrometres in thickness was applied thereto. The connectors for normal connections were masked using a compilation of paper masking, plastic masking, tape masking, dots and latex. The parylene coating was applied using standard techniques under a vacuum of 2-50 mTorr. After applying the parylene coating, the masking was left in position and the PCB was transferred to a vacuum deposition chamber. A target made of indium tin-oxide was vaporised and deposited on the printed circuit board. A transparent layer of 150 Angstrom thick indium tin oxide was applied and this resulted in a resistance of 1000Ω/sq compared to in excess of 10¹⁴Ω/cm for non-conductive parylene-C.

This resulted in an electromagnetic shielding performance of minus 20dB at 100MHz and was sufficient to obtain an interference free circuit.

## Claims

1. A transparent electromagnetic shielding composite which comprises
(i) a transparent insulating layer from 0.1 to 75 micrometres in thickness of a polymeric p-xylylene comprising repeating units of the formula 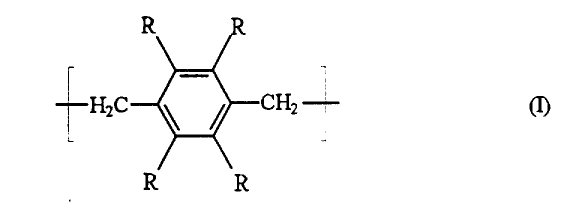 where each R is independently a hydrogen atom, a chlorine atom, a fluorine atom, a carboxyl group or a lower C₁-C₆ alkyl group; and
(ii) a transparent coating on the polymeric p-xylylene layer of indium tin oxide from 10 Angstroms to 50 micrometres in thickness.

2. A shielding composite as claimed in claim 1 which is formed on a substrate surface.

3. A shielding composite as claimed in claim 1 or claim 2 wherein the polymeric p-xylylene layer has a thickness in the range of from 10 to 20 micrometres.

4. A shielding composite as claimed in any one of claims 1 to 3 wherein the indium tin oxide layer has a thickness in the range of from 100 to 10,000 Angstroms.

5. A shielding composite as claimed in any one of the preceding claims wherein the p-xylylene polymer is di-para-xylylene, dichloro-di-para-xylylene tetrachloro-di-para-xylylene, or tetrafluoro-di-para-xylylene.

6. A shielding composite as claimed in any one of the preceding claims which additionally comprises
(iii) a transparent coating on the conductive layer (ii), on the surface opposite the surface adjacent to the polymeric para-xylylene layer (i), of an insulating polymer.

7. A shielding composite as claimed in claim 6 wherein the insulating polymer is a para-xylylene polymer.

8. A shielding composite as claimed in claim 7 wherein the para-xylylene polymer has a thickness in the range of from 0.1 to 75 micrometres.

9. A shielding composite as claimed in claim 8 wherein the para-xylylene polymer has a thickness in the range of from 10 to 20 micrometres.

10. A process for the preparation of an electromagnetic shielding composite, which process comprises the steps of
a) applying to a substrate surface a transparent coating of 0.1 to 75 micrometres in thickness of a polymeric p-xylylene comprising repeating units of the formula 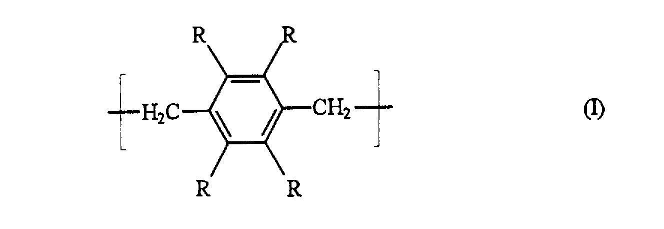 where R is a hydrogen atom, a chlorine atom, a fluorine atom, a carboxyl group or a C₁-C₆ lower alkyl group, by a polymeric vapour deposition process;
b) applying to the polymeric p-xylylene coating a transparent layer of indium tin oxide from 10 Angstroms to 200 micrometres in thickness and
c) optionally applying to the layer of indium tin oxide a coating of a transparent insulating polymeric material.

11. A process as claimed in claim 10 wherein the indium tin oxide coating is applied by a sputtering process and has a thickness of up to 100 micrometres.

12. A process as claimed in claim 10 wherein the indium tin oxide coating is applied by a dip coating process and has a thickness of up to 200 micrometres.
